# EUROPEAN PATENT SPECIFICATION

(11) **EP 4 548 112 B1**
(45) Date of publication and mention of the grant of the patent: **07.10.2026**
(21) Application number: 23736034.2
(22) Date of filing: 27.06.2023
(51) Int. Cl.: G01R 31/396

(54) **METHOD FOR IDENTIFYING BATTERY GROUPS HAVING ONE OR MORE DEFECTIVE CELLS OR CELL CONNECTIONS**
VERFAHREN ZUR IDENTIFIZIERUNG VON BATTERIEGRUPPEN MIT EINER ODER MEHREREN DEFEKTEN ZELLEN ODER ZELLVERBINDUNGEN
PROCÉDÉ D'IDENTIFICATION DE GROUPES DE BATTERIES PRÉSENTANT UN OU PLUSIEURS ÉLÉMENTS OU CONNEXIONS D'ÉLÉMENTS DÉFECTUEUX

(30) Priority: 29.06.2022 SE 2250802
(43) Date of publication of application: 07.05.2025
(73) Proprietor: Scania Industrial Batteries AB, 171 73 Solna (SE)
(72) Inventor: ORTEGA PAREDES, Javier, 114 15 Stockholm (SE); BAKAS, Evangelos, 126 29 Hägersten (SE); MAGNUSSON, Anders, 753 19 Uppsala (SE)
(74) Representative: Brann AB
(86) International application number: PCT/EP2023/067366
(87) International publication number: WO 2024/002995

(56) References cited:
- US-A1- 2022 052 389
- US-A1- 2022 113 354
- YOUNG R E ET AL: "Prediction of individual cell performance in a long-string lead/acid peak-shaving battery: application of artificial neural networks", JOURNAL OF POWER SOURCES, ELSEVIER, AMSTERDAM, NL, vol. 62, no. 1, 1 September 1996 (1996-09-01), pages 121 - 134, XP004071479, ISSN: 0378-7753, DOI: 10.1016/S0378-7753(96)02423-8

## Description

### Technical field

The present disclosure generally relates to batteries comprising battery groups wherein each battery group comprises a plurality of cells. More particularly, the present disclosure relates to identifying battery groups having one or more defective cells or cell connections.

### Background

Rechargeable or secondary batteries find widespread use as electrical power supplies and energy storage systems. A battery may for example comprise a plurality of battery groups wherein each battery group comprises a plurality of cells connected in parallel by means of cell connections. The battery groups may then be connected in series to achieve a desired voltage. For example, in automobiles, battery packs formed of a plurality of battery groups, wherein each battery group includes a plurality of electrochemical cells, are provided as a means of effective storage and utilization of electric power.

US2022052389 relates to a neural network-based method and apparatus for pre-diagnosing defects and fires in battery cells. The apparatus collects chemical composition, current, voltage, and/or temperature data at set intervals during chargedischarge cycles of multiple batteries, trains a neural network with this data, and predicts defective cells by identifying those deviating from the network's main cluster.

Young R. E. et al. relates to a summary of studies on a large energy storage battery to determine whether computerized pattern recognition of maintenance or fabrication data can enable early detection of poorly performing cells and identification of high-performing ones.

US2022113354 relates to a data processing apparatus, a method, and a program for analysing measured data from multiple energy storage devices. The apparatus stores an autoencoder-based determination model trained to reproduce input data from individual devices or device groups. A processor identifies abnormal devices by comparing the input data with the model's reproduced data and calculating the error.

However, there is still a need for alternative and improved monitoring of battery groups, for example in relation to cell failure.

### Summary of the invention

Aspects of the present disclosure relate to identification of battery groups having one or more defective cells or cell connections, and adaptations and improvements in relation to this directed to solving or alleviating the aforementioned problem.

According to a first aspect of the present disclosure, there is provided a method for identifying battery groups having one or more defective cells or cell connections of a plurality of battery groups. Each battery group comprises a plurality of cells connected in parallel. The method comprises obtaining a plurality of voltages, wherein the plurality of voltages comprises a respective voltage for each battery group of the plurality of groups, each voltage being measured at a common point in time when the battery group is in a relaxed state, clustering the plurality of voltages into clusters using a clustering algorithm, and identifying battery groups in clusters having a respective centroid that differs from a reference voltage by more than a first threshold as battery groups having one or more defective cells or cell connections, wherein the reference voltage is the centroid of the voltages of the cluster comprising highest voltages.

By means of the method according to the first aspect, battery groups in having one or more defective cells or cell connections can be identified without the need to have a set reference, such as a reference voltage set or calculated in advance. Instead, the method is based on a realization that when clustering the voltages, the cluster comprising highest voltages will be a good approximation of the group of voltages relating to the battery groups having no defective cells or cell connections. Thus, the centroid of the cluster comprising highest voltages can be used as the reference voltage.

The first threshold may be determined as a function of the reference voltage, wherein a higher reference voltage results in a lower first threshold.

By having the first threshold varying according to a function such that it is lower the higher the reference voltage will increase the precision of the identification of battery groups having one or more defective cells or cell connections since the difference in voltage between the reference voltage and the voltage a battery group having one or more defective cells or cell connections will be lower the higher the state of charge is for the battery group. Furthermore, the reference voltage, i.e. the centroid of the cluster comprising highest voltages, will be higher the higher the state of charge of the battery group.

**The** act of determining the first threshold as a function of the reference voltage may comprise determining a state of charge at the reference voltage from a look-up table, and determining the first threshold as a function of the determined state of charge, wherein a higher state of charge results in a lower first threshold.

**The** first threshold may be determined by means of a supervised machine learning model.

By using a supervised machine learning model, the first threshold can be determined such that the precision of the identification of battery groups having one or more defective cells or cell connections is increased.

The act of identifying battery groups of clusters having a respective centroid that differs from a reference voltage by more than a first threshold as battery groups having one or more defective cells or cell connections may comprise identifying battery groups of clusters having a respective centroid that differs by more than the first threshold and by less than or equal to a second threshold from the reference voltage as battery groups having one defective cell or cell connection, and identifying battery groups of clusters having a respective centroid that differs by more than the second threshold from the reference voltage as battery groups having two or more defective cells or cell connections.

By introducing a second threshold, battery groups having one defective cell or cell connection can be differentiated from battery groups having two or more defective cells or cell connections.

The second threshold may be determined as a function of the reference voltage, wherein a higher reference voltage results in a lower second threshold.

By having the second threshold varying according to a function such that it is lower the higher the reference voltage will increase the precision of the identification of battery groups having one defective cell or cell connection and the identification of battery groups having two or more defective cells or cell connections since the difference in voltage between the reference voltage, the voltage of a battery group having one defective cell or cell connection, and the voltage of a battery group having two or more defective cells or cell connections will be lower the higher the state of charge is for the battery group. Furthermore, the reference voltage, i.e. the centroid of the cluster comprising highest voltages, will be higher the higher the state of charge of the battery group.

The act of determining the second threshold as a function of the reference voltage may comprise determining a state of charge at the reference voltage from a look-up table, and determining the second threshold as a function of the determined state of charge, wherein a higher state of charge results in a lower second threshold.

The second threshold may be determined by means of a supervised machine learning model.

By using a supervised machine learning model, the second threshold can be determined such that the precision of the identification of battery groups having one defective cell or cell connection and of the identification of battery groups having two or more defective cells or cell connections is increased.

In the act of obtaining a plurality of voltages, the common point in time may be selected for which the mean voltage of the respective voltages for each battery group of the plurality of groups corresponds to a state of charge less than 60%, and preferably less than 40%.

By such a selection of the common point in time, the precision of the identification of battery groups having one or more defective cells or cell connections can be increased since the difference in voltage between the reference voltage and the voltage of a battery group having one or more defective cells or cell connections will be higher the lower the state of charge is for the battery group. Furthermore, the reference voltage, i.e. the centroid of the cluster comprising highest voltages, will be higher the higher the state of charge of the battery group. Thus, the lower the state of charge, the larger the distance will be between the clusters.

In the act of obtaining a plurality of voltages, the common point in time may be selected for which the difference between respective voltages for each battery group of the plurality of groups is maximal.

By such a selection of the common point in time, the precision of the identification of battery groups having one or more defective cells or cell connections may be increased since, with larger difference between respective voltages for each battery group of the plurality of groups is, it is more likely that the distance between the clusters will be larger as well.

The plurality of voltages may further comprises a respective further voltage for each battery group of the plurality of groups, each respective further voltage being measured at a further common point in time when the battery group is in a relaxed state, wherein the mean voltage of the respective further voltage for each battery group of the plurality of groups measured at the further common point in time differs less than a predetermined amount from the mean voltage of the respective voltage for each battery group of the plurality of groups measured at the common point in time for which the difference in respective voltages for each battery group of the plurality of groups is maximal.

The act of clustering the plurality of voltages may comprise performing 1D Kernel Distribution Estimation on the plurality of voltages in order to obtain initial clusters, selecting centroids of the initial clusters having a maximum density above a density threshold, and performing one iteration of k-means in order to cluster the data into clusters based on distance minimization.

By using such a clustering algorithm, the cluster comprising highest voltages will be a better approximation of the group of voltages of battery groups having no defective cells or cell connections and the further clusters will be a better approximation of the groups of voltages of battery groups having one or more defective cells or cell connections. Furthermore, the precision in identifying clusters including that groups having one or more defective cells or cell connections is also increased.

According to a second aspect, a computer-readable storage medium having stored thereon instructions for implementing the method according to the first aspect when executed by a device having a processor.

According to a third aspect, a device for identifying battery groups having one or more defective cells or cell connections of a plurality of battery groups is provided, wherein each battery group comprises a plurality of cells connected in parallel. The apparatus comprising circuitry configured to execute an obtaining function configured to obtain a plurality of voltages, wherein the plurality of voltages comprises a respective voltage for each battery group of the plurality of battery groups, each voltage being measured at a common point in time when the battery group is in a relaxed state; a clustering function configured to cluster the plurality of voltages into clusters using a clustering algorithm; and an identifying function configured to identify battery groups of clusters having a respective centroid voltage that differs from a reference voltage by more than a first threshold as battery groups having one or more defective cells or cell connections, wherein the reference voltage is the centroid mean of the voltages of the cluster comprising highest voltages.

The above-mentioned further optional features of the method of the first aspect, when applicable, apply to this third aspect as well.

### Brief description of the drawings

The above and other aspects of the present invention will now be described in more detail, with reference to the appended figures.
Figure 1 shows a flow chart in relation to embodiments of a method of the present disclosure.
Figures 2a and 2b show diagrams of voltage measurement data.
Figure 3 shows a schematic diagram in relation to embodiments of a device of the present disclosure.

### Detailed description

Aspects of the present disclosure will now be described hereinafter with reference to the accompanying drawings, in which currently preferred, exemplary implementations of the disclosed aspects are illustrated.

The invention is applicable in scenarios where a battery comprises battery groups wherein each battery group comprises a plurality of cells connected in parallel by respective cell connections. Each battery group typically comprises the same number of cells. For such a battery, the battery will still function, albeit with reduced performance, even if a cell suffers a failure, e.g. by failure of the cell as such or failure of a cell connection of the cell such that the cell does not supply any voltage or current. Failure of a cell connection means that the cell is no longer electrically connected to the other cells in the battery group. Such failure may for example be due to vibrations, impact, other physical influence on the battery in which the cell is arranged. For example, such vibrations, impact or other physical influence may occur when a battery is arranged in a vehicle. It is to be noted that failure of more than one cell connector in one cell is counted as failure of one cell connection herein, i.e., failure of a cell connection for a cell means that connection is lost for the cell which may be the result of disconnection or other failure of one or more connectors of that cell. Failure of a cell as such may be due to leakage of electrolyte, loss of active material due to corrosion, chemical loss through evaporation, crystal formation, etc. This is also true if more than one cell is lost and/or if one or more cells is lost in more than one battery group. The more cells or cell connections that fail, the more the performance of the battery is reduced. When applying a load to a battery wherein one cell or cell connection has failed in a group, the current from each of the other cells, i.e. the once that are still functioning, will increase. Thus, a battery group having one or more defective cells or cell connections, will discharge faster than an otherwise identical a battery group of the same battery having no defective cells or cell connections. Furthermore, the voltage in relaxed state of a battery group at a point in time will depend on the state of charge of the battery group such that the voltage in relaxed state will be lower the lower the state of charge. Furthermore, as a battery group having one or more defective cells or cell connections will discharge faster, at a point in time after failure of one or more cells or cell connections in a battery group, the state of charge of the battery group having one or more defective cells or cell connections will be lower than the state of charge of a battery group of the same battery having no defective cells or cell connections. Hence, at a point in time, the voltage in relaxed state of a battery group will depend on whether or not the battery group has no or one or more defective cells or cell connections, such that the voltage in relaxed state will be lower for a battery group having one or more defective cells or cell connections than for a battery group having no defective cells or cell connections.

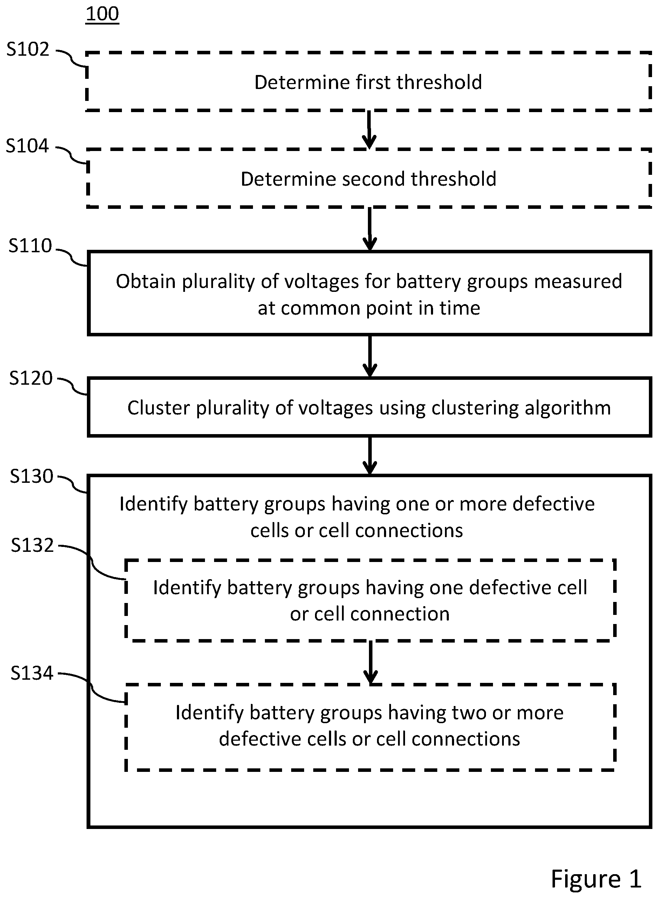

Figure 1 shows a flow chart in relation to embodiments of a method 100 of the present disclosure. In the method 100 battery groups having one or more defective cells or cell connections of a plurality of battery groups are identified. Each battery group comprises a plurality of cells connected in parallel. The identification can be made using voltage measurement for battery groups without the need for any predetermined reference voltage. The method 100 comprises obtaining S110 a plurality of voltages. The plurality of voltages comprises a respective voltage for each battery group of the plurality of groups. Each voltage is measured at a common point in time when the battery group is in a relaxed state. By a common point in time is meant that each voltage is measured within a time period that is sufficiently short that a voltage change during the time period is small in relation to the accuracy of the voltage measurement. The voltage change allowed whilst considering the voltage considered to be measured at a common point in a relaxed state may for example be a voltage within the interval 1-10 mV, such as 4 mV. By the battery group being in a relaxed state is meant that the voltage measurement is performed in a state that is sufficiently close to the ideal relaxed state such that a difference in relation to the voltage at the ideal relaxed state is small in relation to the accuracy of the voltage measurement. This may be achieved by the measurements being performed after a sufficiently long time when the battery groups have not been subject to any load, such as after 10-15 minutes. To identify whether a battery group is in relaxed state, measurements can be made at two points in time with a predefined time between them and determine a difference between the mean voltage of the battery groups at the two points in time. The predefined time may be a time within the interval 1 second - 1 minute, such as 10 seconds. If the difference between the mean voltages is less than a threshold, such as 3 mV, the battery groups are considered to be in a relaxed state. The plurality of voltages is then clustered S120 into clusters using a clustering algorithm. The centroids of the clusters may then be determined and compared to a reference voltage which is an approximation of the voltage of a battery group having no defective cells or cell connections. Since, at a point in time, the voltage in relaxed state of a battery group will depend on whether or not the battery group has no or one or more defective cells or cell connections, such that the voltage in relaxed state will be lower for a battery group having one or more defective cells or cell connections than for a battery group having no defective cells or cell connections, the cluster comprising the highest voltages will approximately comprise the voltages for battery groups having no defective cells or cell connections. Furthermore, assuming that failure of cells and cell connections is fairly infrequent, voltages for most of the battery groups will correspond to voltages for battery groups having no defective cells or cell connections. Depending on the accuracy of the clustering algorithm, the cluster comprising the highest voltages will comprise most of the voltages of the battery groups having no defective cells or cell connections. Thus, the centroid of the comprising the highest voltages is selected as an approximation of the voltage of a battery group having no defective cells or cell connections, i.e. as the reference voltage. Battery groups having a voltage that differs from the reference voltage may then relate to battery groups having one or more defective cells or cell connections depending on how much the difference in voltage is. According to the method 100, battery groups in clusters having a respective centroid that differs from a reference voltage by more than a first threshold are identified S130 as battery groups having one or more defective cells or cell connections.

The difference between the reference voltage and the voltage of a battery group having one or more defective cells or cell connections will increase with a decreased reference voltage. Hence, the first threshold is preferably set to vary as a function of the reference voltage, wherein a lower reference voltage results in a higher first threshold. The first threshold may then be determined S102 from the reference voltage. The first threshold may be determined directly from the reference voltage or via the state of charge. In the latter case, the determining S102 the first threshold may comprise determining a state of charge at the reference voltage from a look-up table, and then determining the first threshold as a function of the determined state of charge, wherein a higher state of charge results in a lower first threshold.

The method 100 may further be include distinguishing battery groups having one defective cell or cell connection from battery groups having two or more defective cells or cell connections. This is achieved by introducing a second threshold. The act of identifying S130 battery groups of clusters having a respective centroid that differs from a reference voltage by more than a first threshold as battery groups having one or more defective cells or cell connections then comprises identifying S132 battery groups of clusters having a respective centroid that differs by more than the first threshold and by less than or equal to a second threshold from the reference voltage as battery groups having one defective cell or cell connection. Battery groups of clusters having a respective centroid that differs by more than the second threshold from the reference voltage are identified S134 as battery groups having two or more defective cells or cell connections.

The difference between the reference voltage and the voltage of a battery group having two or more defective cells or cell connections will increase with a decreased reference voltage. Hence, as for the first threshold, the second threshold is also preferably set to vary as a function of the reference voltage, wherein a lower reference voltage results in a higher second threshold. The second threshold may then be determined S104 from the reference voltage. The second threshold may be determined directly from the reference voltage or via the state of charge. In the latter case, the determining S104 of the second threshold may comprise determining a state of charge at the reference voltage from a look-up table, and then determining the second threshold as a function of the determined state of charge, wherein a higher state of charge results in a lower second threshold.

In addition to the battery groups being in a relaxed state, there are two further preferred requirements, namely that all cells (and battery groups) should be balanced on high state of charge on the last charge of the battery, and that the identification of battery groups having one or more defective cells or cell connections should be done at a state of charge that is relatively low.

That all cells are balanced on a high state of charged on the last charge of the battery means that when the battery is fully or close to fully charged, they have the same voltage or a difference in voltage that is less than a threshold, such as less than 10 mV, or within an interval, such as 5-10 mV if the voltage measurement error is approximately 5 mV. This is preferred since the voltage of a battery group at a point in time after discharging of the battery, i.e. at a lower than 100% state of charge, will depend on the original voltages of its included cells at 100% state of charge. Hence, if the original voltages of the cells differ to much it may become difficult to distinguish a battery group having no defective cells or cell connections from a battery group having one or more defective cells or cell connections even at a point in time when the battery has lower than 100% state of charge, such as 60% state of charge.

That the state of charge that is relatively low may for example mean that the state of charge is 60% or lower. It is preferred to identify battery groups having one or more defective cells or cell connections at a relatively low state of charge since the voltage difference between a battery group having no defective cells or cell connections and a battery group having one or more defective cells or cell connections is higher for a lower state of charge. To identify the state of charge of the battery, the centroid of the cluster comprising the highest voltages should be lower than a voltage corresponding to the highest state of charged desired, e.g. 60%. The voltage corresponding to 60% state of charge can be found in a look up table based on an open circuit voltage - state of charge curve.

The larger the difference between respective voltages for each battery group of the plurality of groups is, the larger the distance will be between the clusters. Hence, in order to further enhance the precision in identification of battery groups having one or more defective cells or cell connections, the common point in time may be selected for which a difference between respective voltages for each battery group of the plurality of groups is maximal. With larger difference between respective voltages for each battery group of the plurality of groups is, it is more likely that the distance between the clusters will be larger as well.

The plurality of voltages may further comprises a respective further voltage for each battery group of the plurality of groups, each respective further voltage being measured at a further common point in time when the battery group is in a relaxed state, wherein the mean voltage of the respective further voltage for each battery group of the plurality of groups measured at the one further common point in time differs less than a predetermined amount, such as 1 mV or 0mV, from the mean voltage of the respective voltage for each battery group of the plurality of groups measured at the common point in time for which the difference in respective voltages for each battery group of the plurality of groups is maximal.

The clustering S120 of the plurality of voltages may comprise performing 1D Kernel Distribution Estimation on the plurality of voltages in order to obtain initial clusters. The centroids of the initial clusters having a maximum density above a density threshold may then be selected. The density threshold may for example be 0.5. One iteration of k-means clustering may then be performed in order to cluster the data into clusters based on distance minimization in relation to the selected centroids as initial means. In alternative, mean-shift clustering may be used as the clustering algorithm.

The clustering S120 may further include re-clustering comprising comparing each voltage of the plurality of voltages to the centroid of the cluster comprising the highest voltages. If the difference of a voltage and the centroid of the cluster comprising the highest voltages is smaller than the first threshold, the voltage is included or kept in the cluster comprising the highest voltages, i.e. corresponding to groups having no defective cells or cell connections. If the difference of a voltage and the centroid of the cluster comprising the highest voltages is larger than the first threshold but smaller than or equal to the second threshold, the voltage is included or kept in the next cluster, i.e. corresponding to groups having one defective cells or cell connections. If the difference of a voltage and the centroid of the cluster comprising the highest voltages is larger than the second threshold, the voltage is included or kept in the next cluster, i.e. corresponding to groups having two or more defective cells or cell connections.

By using a suitable clustering algorithm, the cluster comprising highest voltages may be a better approximation of the group of voltages of battery groups having no defective cells or cell connections and the further clusters will be a better approximation of the groups of voltages of battery groups having one or more defective cells or cell connections.

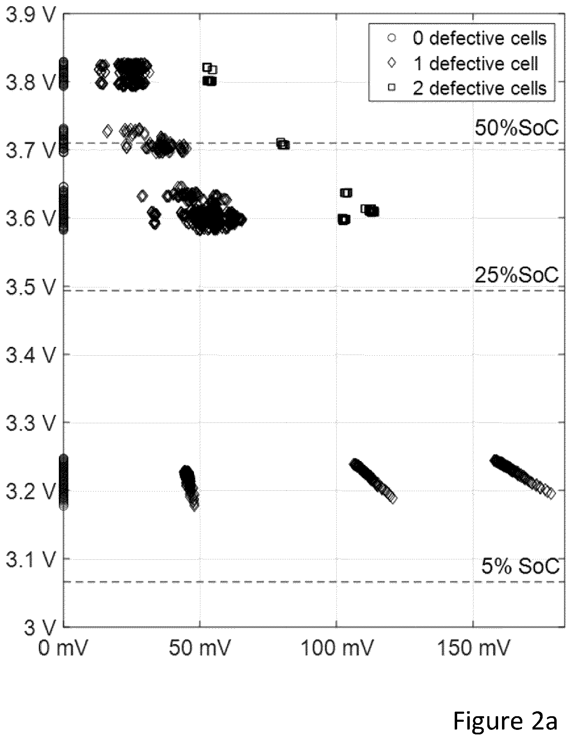

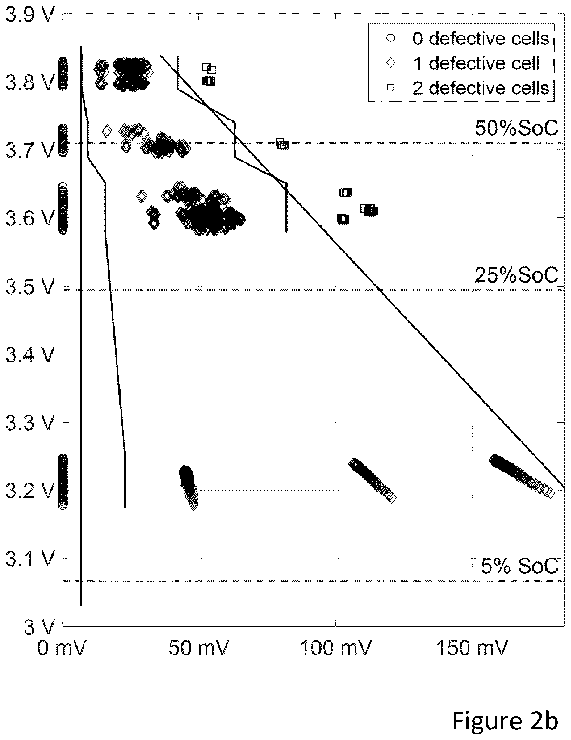

Both the first threshold and the second threshold may be determined by means of a supervised machine learning model. Such determining of the first threshold and optionally the second threshold by means of a supervised machine learning model, such as a support vector machine, will now be described with reference to Figures 2a and 2b showing diagrams of voltage measurement data,

The machine learning model is trained based on a training set formed using voltage measurements for battery groups for which it is known which have no defective cells or cell connections, and which have one or more defective cell or cell connection. If the machine learning model should be able to determine both the first and the second thresholds, the voltage measurements used to form the training set should be for battery groups for which it is known which has no defective cells or cell connections, one defective cell or cell connection, and two or more defective cells or cell connections.

The battery groups and the measurements to be used to form the training set preferably fulfil the requirements that the measurements are made on cells in a relaxed state, and that all cells are balanced on high state of charge. The measurements are then preferably performed over time at different state of charge such that the first threshold and optionally the second threshold is determined for different state of charge in order to determine the first threshold and optionally the second threshold as a respective function of the state of charge. For example, the measurements may be performed at regular intervals such that a series of snapshots of the voltage of each battery group is measured for these snapshots. Snapshots are then selected for training for which the measurements are made on cells in a relaxed state, and that all cells are balanced on high state of charge. To identify whether the measurements are made on cells in a relaxed state a voltage difference between snapshots for each battery group may be compared to a threshold, such as 3 mV. If the voltage difference is less than the threshold for each battery group of the battery, the cells of the battery are considered to be in relaxed state for the snapshots. For a snapshot for which the cells of the battery are considered to be in relaxed state, a check can be done to see if the cells were balanced the last time the battery was fully charged. The cells may be considered to be balanced if the maximum difference in cell voltages between all cells is below a threshold, such as 10 mV. If the measurements are made on cells in a relaxed state and the cells were balanced on high state of charge, the snapshot is used to form the training set.

For each snapshot to be used to form the training data, if there is one or more battery groups with one defective cell or cell connection, the mean voltage for the battery groups with no defective cell or cell connection and the mean voltage for the at least one battery group with one defective cell or cell connection are calculated and stored. Furthermore, the difference between those two stored means is calculated and stored together with an indication that the one or more battery groups has one defective cell or cell connection. Similarly, if there is one or more battery groups with two defective cells or cell connections, the mean voltage for the battery groups with no defective cell or cell connection and the mean voltage for the one or more battery groups with two defective cells or cell connections are calculated and stored. Furthermore, the difference between those two stored means is calculated and stored together with an indication that the one or more battery groups has two defective cells or cell connections. Figure 2a discloses a plot of such means where, for each snapshot, the mean voltage for the battery groups with no defective cell or cell connection is plotted as a black circle at the coordinates corresponding to that mean voltage on the y-axis and at 0 mV difference on the x-axis, the mean voltage for the one or more battery groups with one defective cell or cell connection is plotted as a black rhombus at the coordinates corresponding to that mean voltage on the y-axis and at the difference to the mean voltage for the battery groups with no defective cell or cell connection on the x-axis, and the mean voltage for the one or more battery groups with two defective cell or cell connection is plotted as a black square at the coordinates corresponding to that mean voltage on the y-axis and at the difference to the mean voltage for the battery groups with no defective cell or cell connection on the x-axis.

Once the training set is ready, such as the training set plotted in Figure 2a, a machine learning model, such as a support vector machine, can be trained to determine the first threshold and optionally the second threshold as a function of the reference voltage, which is the mean voltage for the battery groups with no defective cell or cell connection. The support vector machine may try to find a first threshold for a reference voltage that separates the mean voltage for the battery groups with no defective cell or cell connection for each snapshot from the mean voltage for the battery groups with one defective cell or cell connection for each snapshot. The support vector machine may further try to find a second threshold for a reference voltage that separates the mean voltage for the battery groups with one defective cell or cell connection for each snapshot from the mean voltage for the battery groups with two defective cells or cell connections for each snapshot. Two alternative approaches may be used, a step-stair decision boundary and a continuous hyperplane. The stair-step model is accurate for predictions for reference voltages at which they are computed, and they include hyperplanes with the form of x = constant, approximately for intervals of reference voltages at which they are computed, i.e. for which there are mean voltage for the battery groups with no defective cell or cell connection, as illustrated in Figure 2b. The intervals selected for the step-stair model are based on the reference voltage data points that were available for training the machine learning model, i.e. the support vector machine. For reference voltages for which there is no data, i.e. no mean voltage for the battery groups with no defective cell or cell connection in the training set, the first threshold is interpolated (lower slopes in Figure 2b) based on the ending of the first threshold above and the beginning of the first threshold below. The first threshold for the approach using a continuous hyperplane is illustrated as the straight vertical line in Figure 2b and the second threshold for the approach using a continuous hyperplane is illustrated as the continuous straight sloping line in Figure 2b.

The indications 50%, 25% and 5% at approximately 3.7 V, 3.5 V, and 3.1 V, respectively, in Figures 2a and 2b relate to the state of charge corresponding the respective voltage levels.

The machine learning model may be trained with the MATLAB function svmTrain.m which uses a linear kernel that computes a hyperplane between data that maximizes the distance from both mean voltages, i.e. the mean voltage for the battery groups with no defective cell or cell connection for each snapshot from the mean voltage for the battery groups with one defective cell or cell connection for each snapshot, and optionally the mean voltage for the battery groups with one defective cell or cell connection for each snapshot from the mean voltage for the battery groups with two defective cells or cell connections for each snapshot. In other words, the training tries to fit the line that separates both mean voltages at a distance which is approximately equal for both mean voltages.

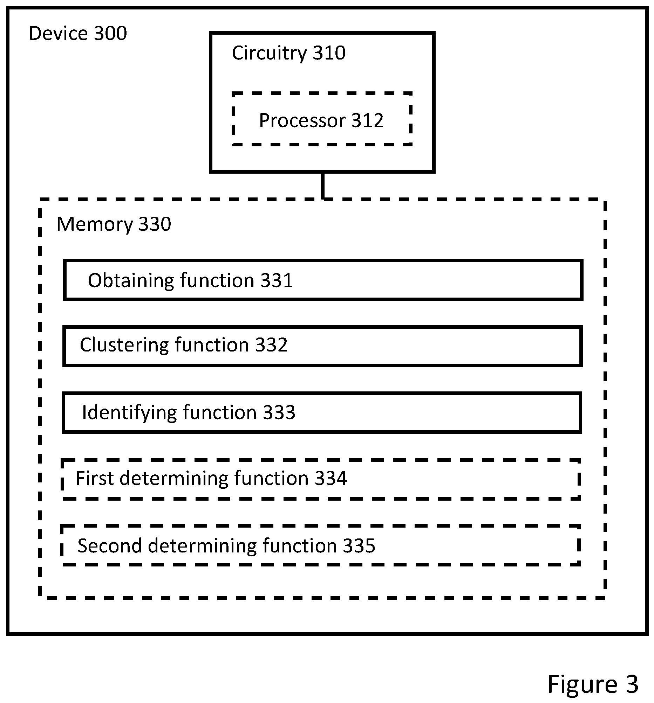

Figure 3 shows a schematic diagram in relation to embodiments of a device 300 of the present disclosure. The device 300 is arranged for identifying battery groups having one or more defective cells or cell connections of a plurality of battery groups, wherein each battery group comprises a plurality of cells connected in parallel. For example, the steps of the embodiments of the method 100 described in connection with Figure 1 may be performed by the device 300 described in connection with Figure 3.

The device 300 comprises a circuitry 320. The circuitry 320 is configured to carry out functions of device 300. The circuitry 320 may include a processor 322, such as a central processing unit (CPU), microcontroller, or microprocessor. The processor 322 is configured to execute program code. The program code may for example be configured to carry out the functions of the device 300.

The device 300 may further comprise a memory 330. The memory 330 may be one or more of a buffer, a flash memory, a hard drive, a removable media, a volatile memory, a non-volatile memory, a random access memory (RAM), or another suitable device. In a typical arrangement, the memory 330 may include a non-volatile memory for long term data storage and a volatile memory that functions as device memory for the circuitry 320. The memory 330 may exchange data with the circuitry 320 over a data bus. Accompanying control lines and an address bus between the memory 330 and the circuitry 320 also may be present.

Functions of the device 300 may be embodied in the form of executable logic routines (e.g., lines of code, software programs, etc.) that are stored on a nontransitory computer readable medium (e.g., the memory 330) of the device 300 and are executed by the circuitry 320 (e.g., using the processor 322). Furthermore, the functions of the device 300 may be a stand- alone software application or form a part of a software application that carries out additional tasks and functions related to the device 300. The described functions may be considered a method that a processing unit, e.g. the processor 322 of the circuitry 320 is configured to carry out. Also, while the described functions may be implemented in software, such functions may as well be carried out via dedicated hardware or firmware, or some combination of hardware, firmware and/or software.

The circuitry 320 is configured to execute an obtaining function 331, a clustering function 332, and an identifying function 333.

The obtaining function 331 is configured to obtain a plurality of voltages, wherein the plurality of voltages comprises a respective voltage for each battery group of the plurality of battery groups, each voltage being measured at a common point in time when the battery group is in a relaxed state.

The clustering function 332 is configured to cluster the plurality of voltages into clusters using a clustering algorithm.

The identifying function 333 is configured to identify battery groups of clusters having a respective centroid voltage that differs from a reference voltage by more than a first threshold as battery groups having one or more defective cells or cell connections, wherein the reference voltage is the centroid mean of the voltages of the cluster comprising highest voltages.

The functions carried out by the circuitry 320 may be further adapted as the corresponding steps of the embodiments of the method 100 described in relation to Figure 1. Additionally, the circuitry 320 may be further configured to execute a first determining function 334 configured to determine the first threshold and a second determining function 335 configured to determine the second threshold as disclosed in the corresponding steps of the embodiments of the method 100 described in relation to Figure 1.

Furthermore, whilst the forgoing description and the appended drawings are provided as exemplary or preferred realizations of the disclosed aspects, it will be appreciated that the disclosed aspects need not be limited to the exact form shown and/or described.

## Claims

1. A method (100) for identifying battery groups having one or more defective cells or cell connections of a plurality of battery groups, wherein each battery group comprises a plurality of cells connected in parallel, the method comprising:
obtaining (S110) a plurality of voltages, wherein the plurality of voltages comprises a respective voltage for each battery group of the plurality of battery groups, each voltage being measured at a common point in time when the battery group is in a relaxed state;
clustering (S120) the plurality of voltages into clusters using a clustering algorithm; and
**characterized in that** the method (100) further comprises identifying (S130) battery groups of clusters having a respective centroid that differs from a reference voltage by more than a first threshold as battery groups having one or more defective cells or cell connections, wherein the reference voltage is the centroid of the cluster comprising highest voltages.

2. The method (100) of claim 1, further comprising:
determining (S102) the first threshold as a function of the reference voltage, wherein a higher reference voltage results in a lower first threshold.

3. The method (100) of claim 2, wherein the act of determining the first threshold as a function of the reference voltage comprises:
determining a state of charge at the reference voltage from a look-up table; and
determining the first threshold as a function of the determined state of charge, wherein a higher state of charge results in a lower first threshold.

4. The method (100) of claim 2 or 3, wherein the first threshold is determined by means of a supervised machine learning model.

5. The method (100) of any one of the preceding claims, wherein the act of identifying battery groups of clusters having a respective centroid that differs from a reference voltage by more than a first threshold as battery groups having one or more defective cells or cell connections comprises:
identifying battery groups of clusters having a respective centroid that differs by more than the first threshold and by less than or equal to a second threshold from the reference voltage as battery groups having one defective cell or cell connection; and
identifying battery groups of clusters having a respective centroid that differs by more than the second threshold from the reference voltage as battery groups having two or more defective cells or cell connections.

6. The method (100) of claim 5, further comprising:
determining (S104) the second threshold as a function of the reference voltage, wherein a higher reference voltage results in a lower second threshold.

7. The method (100) of claim 6, wherein the act of determining the second threshold as a function of the reference voltage comprises:
determining a state of charge at the reference voltage from a look-up table; and
determining the second threshold as a function of the determined state of charge, wherein a higher state of charge results in a lower second threshold.

8. The method (100) of claim 6 or 7, wherein the second threshold is determined by means of a supervised machine learning model.

9. The method (100) of any of the preceding claims, wherein, in the act of obtaining (S110) a plurality of voltages, the common point in time is selected for which the mean voltage of the respective voltages for each battery group of the plurality of battery groups corresponds to a state of charge less than 60%, and preferably less than 40%.

10. The method (100) of any one of preceding claims 1-8, wherein, in the act of obtaining (S110) a plurality of voltages, the common point in time is selected for which the difference between respective voltages for each battery group of the plurality of battery groups is maximal.

11. The method (100) of claim 10, wherein the plurality of voltages further comprises a respective further voltage for each battery group of the plurality of battery groups, each respective further voltage being measured at a further common point in time when the battery group is in a relaxed state, wherein the mean voltage of the respective further voltage for each battery group of the plurality of battery groups measured at of the further common point in time differs less than a predetermined amount from the mean voltage of the respective voltage for each battery group of the plurality of groups measured at the common point in time for which the difference in respective voltages for each battery group of the plurality of battery groups is maximal.

12. The method (100) of any one of the preceding claims, wherein the act of clustering (S120) the plurality of voltages comprises:
performing 1D Kernel Distribution Estimation on the plurality of voltages in order to obtain initial clusters;
selecting centroids of the initial clusters having a maximum density above a density threshold; and
performing one iteration of k-means clustering in order to cluster the data into clusters based on distance minimization.

13. A computer-readable storage medium having stored thereon instructions for implementing the method (100) according to any one of claims 1 to 12 when executed by a device having a processor.

14. A device (300) for identifying battery groups having one or more defective cells or cell connections of a plurality of battery groups, wherein each battery group comprises a plurality of cells connected in parallel, the apparatus comprising circuitry (320) configured to execute:
an obtaining function (331) configured to obtain a plurality of voltages, wherein the plurality of voltages comprises a respective voltage for each battery group of the plurality of battery groups, each voltage being measured at a common point in time when the battery group is in a relaxed state;
a clustering function (332) configured to cluster the plurality of voltages into clusters using a clustering algorithm; and
**characterized in that** the device further comprises an identifying function (333) configured to identify battery groups of clusters having a respective centroid voltage that differs from a reference voltage by more than a first threshold as battery groups having one or more defective cells or cell connections, wherein the reference voltage is the centroid mean of the voltages of the cluster comprising highest voltages.

## Patentansprüche

1. Verfahren (100) zum Identifizieren von Batteriegruppen mit einer oder mehreren defekten Zellen oder Zellverbindungen einer Vielzahl von Batteriegruppen, wobei jede Batteriegruppe eine parallel geschaltete Vielzahl von Zellen umfasst, wobei das Verfahren Folgendes umfasst:
Erhalten (S110) einer Vielzahl von Spannungen, wobei die Vielzahl von Spannungen eine jeweilige Spannung für jede Batteriegruppe der Vielzahl von Batteriegruppen umfasst, wobei jede Spannung zu einem gemeinsamen Zeitpunkt gemessen wird, wenn sich die Batteriegruppe in einem entspannten Zustand befindet;
Clustern (S120) der Vielzahl von Spannungen zu Clustern unter Verwendung eines Clustering-Algorithmus; und
**dadurch gekennzeichnet, dass** das Verfahren (100) ferner Identifizieren (S130) von Batteriegruppen von Clustern, die einen jeweiligen Schwerpunkt aufweisen, der sich von einer Referenzspannung um mehr als einen ersten Schwellenwert unterscheidet, als Batteriegruppen mit einer oder mehreren defekten Zellen oder Zellverbindungen umfasst, wobei die Referenzspannung der Schwerpunkt des Clusters ist, der die höchsten Spannungen umfasst.

2. Verfahren (100) nach Anspruch 1, ferner umfassend:
Bestimmen (S102) des ersten Schwellenwerts in Abhängigkeit der Referenzspannung, wobei eine höhere Referenzspannung einen niedrigeren ersten Schwellenwert ergibt.

3. Verfahren (100) nach Anspruch 2, wobei der Vorgang des Bestimmens des ersten Schwellenwerts in Abhängigkeit der Referenzspannung Folgendes umfasst:
Bestimmen eines Ladezustands bei der Referenzspannung anhand einer Nachschlagetabelle; und
Bestimmen des ersten Schwellenwerts in Abhängigkeit des bestimmten Ladezustands, wobei ein höherer Ladezustand einen niedrigeren ersten Schwellenwert ergibt.

4. Verfahren (100) nach Anspruch 2 oder 3, wobei der erste Schwellenwert mittels eines Modells für überwachtes maschinelles Lernen bestimmt wird.

5. Verfahren (100) nach einem der vorhergehenden Ansprüche, wobei der Vorgang des Identifizierens von Batteriegruppen von Clustern, die einen jeweiligen Schwerpunkt aufweisen, der sich von einer Referenzspannung um mehr als einen ersten Schwellenwert unterscheidet, als Batteriegruppen mit einer oder mehreren defekten Zellen oder Zellverbindungen Folgendes umfasst:
Identifizieren von Batteriegruppen von Clustern, die einen jeweiligen Schwerpunkt aufweisen, der sich von der Referenzspannung um mehr als den ersten Schwellenwert und um weniger als oder gleich einem zweiten Schwellenwert unterscheidet, als Batteriezellen mit einer defekten Zelle oder Zellverbindung; und
Identifizieren von Batteriegruppen von Clustern, die einen jeweiligen Schwerpunkt aufweisen, der sich von der Referenzspannung um mehr als den zweiten Schwellenwert unterscheidet, als Batteriegruppen mit zwei oder mehr defekten Zellen oder Zellverbindungen.

6. Verfahren (100) nach Anspruch 5, ferner umfassend:
Bestimmen (S104) des zweiten Schwellenwerts in Abhängigkeit der Referenzspannung, wobei eine höhere Referenzspannung einen niedrigeren zweiten Schwellenwert ergibt.

7. Verfahren (100) nach Anspruch 6, wobei der Vorgang des Bestimmens des zweiten Schwellenwerts in Abhängigkeit der Referenzspannung Folgendes umfasst:
Bestimmen eines Ladezustands bei der Referenzspannung anhand einer Nachschlagetabelle; und
Bestimmen des zweiten Schwellenwerts in Abhängigkeit des bestimmten Ladezustands, wobei ein höherer Ladezustand einen niedrigeren zweiten Schwellenwert ergibt.

8. Verfahren (100) nach Anspruch 6 oder 7, wobei der zweite Schwellenwert mittels eines Modells für überwachtes maschinelles Lernen bestimmt wird.

9. Verfahren (100) nach einem der vorhergehenden Ansprüche, wobei bei dem Vorgang des Erhaltens (S110) einer Vielzahl von Spannungen der gemeinsame Zeitpunkt ausgewählt wird, bei dem die mittlere Spannung der jeweiligen Spannungen für jede Batteriegruppe der Vielzahl von Batteriegruppen einem Ladezustand von weniger als 60 % und vorzugsweise weniger als 40 % entspricht.

10. Verfahren (100) nach einem der vorhergehenden Ansprüche 1-8, wobei bei dem Vorgang des Erhaltens (S110) einer Vielzahl von Spannungen der gemeinsame Zeitpunkt ausgewählt wird, bei dem die Differenz zwischen jeweiligen Spannungen für jede Batteriegruppe der Vielzahl von Batteriegruppen am höchsten ist.

11. Verfahren (100) nach Anspruch 10, wobei die Vielzahl von Spannungen ferner eine jeweilige weitere Spannung für jede Batteriegruppe der Vielzahl von Batteriegruppen umfasst, wobei jede jeweilige weitere Spannung zu einem weiteren gemeinsamen Zeitpunkt gemessen wird, wenn sich die Batteriegruppe in einem entspannten Zustand befindet, wobei sich die mittlere Spannung der jeweiligen weiteren Spannung für jede Batteriegruppe der Vielzahl von Batteriegruppen, die zu dem weiteren Zeitpunkt gemessen wird, um weniger als einen vorgegebenen Betrag von der mittleren Spannung der jeweiligen Spannung für jede Batteriegruppe der Vielzahl von Gruppen unterscheidet, die zu dem gemeinsamen Zeitpunkt gemessen wird, bei dem die Differenz der jeweiligen Spannungen für jede Batteriegruppe der Vielzahl von Batteriegruppen am höchsten ist.

12. Verfahren (100) nach einem der vorhergehenden Ansprüche, wobei der Vorgang des Clusterns (S120) der Vielzahl von Spannungen Folgendes umfasst:
Durchführen einer 1D-Kerndichteschätzung an der Vielzahl von Spannungen, um Anfangscluster zu erhalten;
Auswählen von Schwerpunkten der Anfangscluster, die eine maximale Dichte über einem Dichteschwellenwert aufweisen; und
Durchführen einer Iteration von k-Means-Clustering, um die Daten zu Clustern auf Grundlage einer Distanzminimierung zu clustern.

13. Computerlesbares Speichermedium, auf dem Anweisungen zum Umsetzen des Verfahrens (100) nach einem der Ansprüche 1 bis 12 bei Ausführung durch eine einen Prozessor aufweisenden Vorrichtung gespeichert sind.

14. Vorrichtung (300) zum Identifizieren von Batteriegruppen mit einer oder mehreren defekten Zellen oder Zellverbindungen einer Vielzahl von Batteriegruppen, wobei jede Batteriegruppe eine parallel geschaltete Vielzahl von Zellen umfasst, wobei die Vorrichtung eine Schaltung (320) umfasst, die zum Ausführen von Folgendem ausgelegt ist:
einer Erhaltungsfunktion (331), die dazu ausgelegt ist, eine Vielzahl von Spannungen zu erhalten, wobei die Vielzahl von Spannungen eine jeweilige Spannung für jede Batteriegruppe der Vielzahl von Batteriegruppen umfasst, wobei jede Spannung zu einem gemeinsamen Zeitpunkt gemessen wird, wenn sich die Batteriegruppe in einem entspannten Zustand befindet;
einer Clustering-Funktion (332), die dazu ausgelegt ist, die Vielzahl von Spannungen zu Clustern unter Verwendung eines Clustering-Algorithmus zu clustern; und
**dadurch gekennzeichnet, dass** die Vorrichtung ferner eine Identifizierungsfunktion (333) umfasst, die dazu ausgelegt ist, Batteriegruppen von Clustern, die einen jeweiligen Schwerpunkt aufweisen, der sich von einer Referenzspannung um mehr als einen ersten Schwellenwert unterscheidet, als Batteriegruppen mit einer oder mehreren defekten Zellen oder Zellverbindungen zu identifizieren, wobei die Referenzspannung der Schwerpunktmittelwert der Spannungen des Clusters ist, der die höchsten Spannungen umfasst.

## Revendications

1. Procédé (100) destiné à identifier des groupes de batteries ayant un ou plusieurs éléments ou connexions d'éléments défectueux parmi une pluralité de groupes de batteries, dans lequel chaque groupe de batteries comprend une pluralité d'éléments connectés en parallèle, le procédé comprenant :
l'obtention (S110) d'une pluralité de tensions, dans lequel la pluralité de tensions comprend une tension respective pour chaque groupe de batteries parmi la pluralité de groupes de batteries, chaque tension étant mesurée au niveau d'un point temporel commun lorsque le groupe de batteries est dans un état au repos ;
le partitionnement (S120) de la pluralité de tensions en partitions à l'aide d'un algorithme de partitionnement ; et
**caractérisé en ce que** le procédé (100) comprend en outre l'identification (S130) de groupes de batteries dont les partitions ont un centroïde respectif qui diffère d'une tension de référence de plus d'un premier seuil en tant que groupes de batteries ayant une ou plusieurs éléments ou connexions d'éléments défectueux, dans lequel la tension de référence est le centroïde de la partition comprenant les tensions les plus élevées.

2. Procédé (100) selon la revendication 1, comprenant en outre :
la détermination (S102) du premier seuil en fonction de la tension de référence, dans lequel une tension de référence plus élevée conduit à un premier seuil plus faible.

3. Procédé (100) selon la revendication 2, dans lequel l'action de détermination du premier seuil en fonction de la tension de référence comprend :
la détermination d'un état de charge à la tension de référence à partir d'une table de consultation ; et
la détermination du premier seuil en fonction de l'état de charge déterminé, dans lequel un état de charge plus élevé conduit à un premier seuil plus faible.

4. Procédé (100) selon la revendication 2 ou 3, dans lequel le premier seuil est déterminé au moyen d'un modèle d'apprentissage machine supervisé.

5. Procédé (100) selon l'une quelconque des revendications précédentes, dans lequel l'action d'identifier des groupes de batteries dont les partitions ont un centroïde respectif qui diffère d'une tension de référence de plus d'un premier seuil en tant que groupes de batteries ayant une ou plusieurs éléments ou connexions d'éléments défectueux comprend :
l'identification de groupes de batteries dont les partitions ont un centroïde respectif qui diffère de la tension de référence d'une quantité supérieure au premier seuil et inférieure ou égale à un deuxième seuil en tant que groupes de batteries ayant un élément défectueux ou une connexion d'élément défectueuse ; et
l'identification de groupes de batteries dont les partitions ont un centroïde respectif qui diffère de la tension de référence d'une quantité supérieure au deuxième seuil en tant que groupes de batteries ayant deux ou plus éléments ou connexions d'éléments défectueux.

6. Procédé (100) selon la revendication 5, comprenant en outre :
la détermination (S104) du deuxième seuil en fonction de la tension de référence, dans lequel une tension de référence plus élevée conduit à un deuxième seuil plus faible.

7. Procédé (100) selon la revendication 6, dans lequel l'action de détermination du deuxième seuil en fonction de la tension de référence comprend :
la détermination d'un état de charge à la tension de référence à partir d'une table de consultation ; et
la détermination du deuxième seuil en fonction de l'état de charge déterminé, dans lequel un état de charge plus élevé conduit à un deuxième seuil plus faible.

8. Procédé (100) selon la revendication 6 ou 7, dans lequel le deuxième seuil est déterminé au moyen d'un modèle d'apprentissage machine supervisé.

9. Procédé (100) selon l'une quelconque des revendications précédentes, dans lequel, dans l'action d'obtention (S110) d'une pluralité de tensions, le point temporel commun est sélectionné pour celui dont la tension moyenne des tensions respectives pour chaque groupe de batteries parmi la pluralité de groupes de batteries correspond à un état de charge inférieur à 60 %, et de préférence inférieur à 40 %.

10. Procédé (100) selon l'une quelconque des revendications précédentes 1 à 8, dans lequel, dans l'action d'obtention (S110) d'une pluralité de tensions, le point temporel commun est sélectionné pour celui dont la différence entre les tensions respectives pour chaque groupe de batteries parmi la pluralité de groupes de batteries est maximale.

11. Procédé (100) selon la revendication 10, dans lequel la pluralité de tensions comprend en outre une tension supplémentaire respective pour chaque groupe de batteries parmi la pluralité de groupes de batteries, chaque tension supplémentaire respective étant mesurée au niveau d'un autre point temporel commun lorsque le groupe de batteries est dans un état au repos, dans lequel la tension moyenne de la tension supplémentaire respective pour chaque groupe de batteries parmi la pluralité de groupes de batteries mesurée audit autre point temporel commun diffère de moins d'une quantité prédéterminée par rapport à la tension moyenne de la tension respective pour chaque groupe de batteries parmi la pluralité de groupes mesurée au niveau du point temporel commun pour lequel la différence de tensions respectives pour chaque groupe de batteries parmi la pluralité de groupes de batteries est maximale.

12. Procédé (100) selon l'une quelconque des revendications précédentes, dans lequel l'action de partitionnement (S120) de la pluralité de tensions comprend :
la réalisation d'une estimation de la densité par noyau en une dimension sur la pluralité de tensions afin d'obtenir des partitions initiales ;
la sélection de centroïdes parmi les partitions initiales ayant une densité maximale au-dessus d'un seuil de densité ; et
la réalisation d'une itération de partitionnement à k moyennes afin de partitionner les données en partitions sur la base d'une réduction au minimum de la distance.

13. Support de stockage lisible par ordinateur sur lequel sont stockées des instructions pour mettre en oeuvre le procédé (100) selon l'une quelconque des revendications 1 à 12 lorsqu'il est exécuté par un dispositif ayant un processeur.

14. Dispositif (300) destiné à identifier des groupes de batteries ayant un ou plusieurs éléments ou connexions d'éléments défectueux parmi une pluralité de groupes de batteries, dans lequel chaque groupe de batteries comprend une pluralité d'éléments connectés en parallèle, l'appareil comprenant une circuiterie (320) configurée pour exécuter :
une fonction d'obtention (331) configurée pour obtenir une pluralité de tensions, dans lequel la pluralité de tensions comprend une tension respective pour chaque groupe de batteries parmi la pluralité de groupes de batteries, chaque tension étant mesurée au niveau d'un point temporel commun lorsque le groupe de batteries est dans un état au repos ;
une fonction de partitionnement (332) configurée pour partitionner la pluralité de tensions en partitions à l'aide d'un algorithme de partitionnement ; et
**caractérisé en ce que** le dispositif comprend en outre une fonction d'identification (333) configurée pour identifier des groupes de batteries dont les partitions ont une tension centroïde respective qui diffère d'une tension de référence de plus d'un premier seuil en tant que groupes de batteries ayant une ou plusieurs éléments ou connexions d'éléments défectueux, dans lequel la tension de référence est la moyenne centroïde des tensions de la partition comprenant les tensions les plus élevées.
